# EUROPÄISCHE PATENTSCHRIFT

(11) **EP 2 695 499 B1**
(45) Veröffentlichungstag und Bekanntmachung des Hinweises auf die Patenterteilung: **15.08.2018**
(21) Anmeldenummer: 12714640.5
(22) Anmeldetag: 04.04.2012
(51) Int. Cl.: H05K 5/06, H05K 5/00

(54) **GEHÄUSESEITIGE TRENNSCHICHT ZUR STRESSENTKOPPLUNG VON VERGOSSENEN ELEKTRONIKEN**
HOUSING-SIDE SEPARATING LAYER FOR THE STRESS DECOUPLING OF POTTED ELECTRONICS
COUCHE DE SÉPARATION DU CÔTÉ BOÎTIER POUR LE DÉCOUPLAGE DES CONTRAINTES D'ÉLECTRONIQUES SCELLÉES

(30) Priorität: 07.04.2011 DE 102011007012; 09.11.2011 DE 102011086048
(43) Veröffentlichungstag der Anmeldung: 12.02.2014
(73) Patentinhaber: Continental Teves AG & Co. oHG, 60488 Frankfurt (DE)
(72) Erfinder: HUBER, Dietmar, 63322 Rödermark (DE); SCHILLINGER, Jakob, 85080 Gaimersheim (DE); THEOBALD, Dirk, 65760 Eschborn (DE)
(74) Vertreter: Höer, Daniela
(86) Internationale Anmeldenummer: PCT/EP2012/056139
(87) Internationale Veröffentlichungsnummer: WO 2012/136692

(56) Entgegenhaltungen:
- EP-A1- 0 113 073
- EP-A1- 0 398 108
- EP-A2- 0 205 746
- DE-U1-202007 003 687
- US-A1- 2009 050 957

## Beschreibung

Die vorliegende Erfindung betrifft eine Vorrichtung umfassend ein Substrat zum Tragen einer elektrischen Schaltung, ein Gehäuse zum Einhausen des Substrats und eine im Gehäuse aufgenommene Vergussmasse, die das Substrat wenigstens teilweise umgibt sowie ein Verfahren zum Herstellen einer derartigen Vorrichtung.

Die Vergussmasse schützt das Substrat im Gehäuse gegen Umwelteinflüsse. Desweiteren könnte die Vergussmasse die Leiterplatte im Gehäuse auch mechanisch fixieren. Das Substrat kann dabei vollständig von der Vergussmasse umschlossen sein.

In diesem Zusammenhang beschreibt die US 2009/050957 A1 ein Halbleiterbauelement, welches ein metallisches Basissubstrat zur Wärmeableitung aufweist, eine Leiterplatte, einen MOSFET, nach außen führende Anschlüsse, ein Gehäuse aus einem synthetischen Harz, ein Fixierharz und eine gelartige Harzschicht. Auf dem metallischen Basissubstrat ist das Gehäuse derart angeordnet, dass es ein Ende der nach außen führenden Anschlüsse einfasst. Das andere Ende der nach außen führenden Anschlüsse ragt aus dem Gehäuse hervor und Teilbereiche der Anschlüsse sind als Verbindungsstücke durch Öffnungen im Gehäuse hindurch geführt. Die Teilbereiche der Anschlüsse sowie die Öffnungen sind mit dem Fixierharz befestigt und die gelartige Harzschicht ist am unteren Teil des Gehäuses ausgebildet.

Aus der EP 0 205 746 A2 ist ein Leistungshalbleitermodul mit einem großflächigen Keramiksubstrat als Bodenfläche bekannt. Bei solchen Modulen zieht sich während der Fertigung das Keramiksubstrat oftmals hohl, so dass nach dem Aufbringen auf einen Kühlkörper kein guter thermischer Kontakt besteht. Die EP 0 205 746 A2 schlägt daher vor, in das Modul Stützen einzusetzen, die das Keramiksubstrat gegenüber dem Gehäuse so abstützen, dass das Keramiksubstrat eben bzw. an gewünschten Stellen leicht konvex gewölbt ist. Durch geeignete Wahl der Materialausdehnungskoeffizienten und entsprechende Dimensionierung der Stützen wird erreicht, dass sich das gewünschte Ergebnis ohne besondere Montagehilfen einstellt.

Die EP 0 398 108 A1 beschreibt Leistungshalbleitermodule mit Kunststoffgehäusen, die mit Vergussmasse gefüllt sind. Die Vergussmasse kann beim Härten und Abkühlen durch Schrumpfung oftmals eine unerwünschte konvexe Krümmung des Gehäusebodens bewirken. Die EP 0 398 108 A1 schlägt daher eine besondere Gestaltung des Kunststoffgehäuses vor, wobei eine Gehäusewand des Kunststoffgehäuses derart zu einem Federmechanismus gefaltet ist, dass ein Innenteil des Gehäuses elastisch mit einem äußeren Rahmen verbunden ist.

Die DE 20 2007 003687 U1 offenbart eine Anordnung mit
- einem Gehäuse, welches wenigstens aus einem zylindrischen Hohlrohr besteht,
- einer Mehrzahl von in das Gehäuse eingebrachten elektronischen Bauelementen
- und einer Vergussmasse, welche die elektronischen Bauelemente umschließt, den Raum zwischen diesen und der Innenwand des Hohlrohres ausfüllt und hierdurch die elektronischen Bauelemente in dem Hohlrohr haltert, wobei das Hohlrohr im Bereich der Vergussmasse an seiner Innenwand eine spiralförmig um die Rohrachse verlaufende erste Rille sowie eine hierzu gegenläufig spiralförmig um die Rohrachse verlaufende zweite Rille aufweist, so dass die Vergussmasse in beide Rillen eingreift und die elektronischen Bauelemente über die in beide Rillen eingreifende Vergussmasse formschlüssig in dem Hohlrohr fixiert sind.

Es ist eine Aufgabe der Erfindung, die Vorrichtung zu verbessern.

Die Aufgabe wird durch die Merkmale der unabhängigen Ansprüche gelöst. Bevorzugte Weiterbildungen der Erfindung sind Gegenstand der abhängigen Ansprüche.

Die Erfindung schlägt vor, in dem Gehäuse eine Wandung auszubilden. Dabei kann die Vergussmasse am Gehäuse haften und sich von der Wandung lösen.

Der Erfindung geht davon aus, dass die Vergussmasse an den inneren Wandungen des Gehäuses haften sollte. Beim Aushärten der Vergussmasse, was bei der Verwendung eines Kunststoffes als Vergussmasse durch polymerisieren geschehen könnte, schrumpft die Vergussmasse abhängig vom verwendeten Material signifikant. Diese Schrumpfung erzeugt eine Zugbeanspruchung auf das Substrat, und auf die elektronischen Bauelemente, die auf dem Substrat montiert sind.

Der Erfindung liegt dazu die Überlegung zugrunde, dass diese auf die elektronischen Bauelemente einwirkende Zugbeanspruchung durch die Vergussmasse im Wesentlichen zu einer Zugkraft führt, die die elektrischen Kontaktierungsstellen zwischen den elektrischen Bauelementen, wie Lötstellen, Klebestellen oder Drahtbondstellen, mechanisch beansprucht. Das Problem verschärft sich bei wechselnden mechanischen Beanspruchungen, wie sie aufgrund von Wärmeausdehnungsprozessen der Vergussmasse bei Temperaturschwankungen auftreten können. Letztendlich kann die auf die elektronischen Bauelemente einwirkende Zugbeanspruchung für Risse in den elektrischen Kontaktierungsstellen verantwortlich sein, die zum Ausfall der gesamten durch das Substrat getragenen elektrischen Schaltung führen.

Der Erfindung liegt ferner die Überlegung zugrunde, dass ein Entspannungsspalt zwischen dem Substrat und der Vergussmasse diese auf die elektronischen Bauelemente einwirkende Zugbeanspruchung reduzieren könnte. Dieser Entspannungsspalt kann aber laterale Bewegungen zwischen einer Oberfläche des Substrates und der Vergussmasse nicht vermeiden, so dass die Vergussmasse auf die elektronischen Bauelemente und ihre elektrischen Kontaktierungsstellen immer noch mit Scherkräften wirken kann, die zu dem oben genannten Ausfall der gesamten durch das Substrat getragenen Schaltung führen können.

Demgegenüber schlägt die Erfindung vor, den Entspannungsspalt nicht am Substrat sondern gehäuseseitig ausbilden zu lassen. Damit ist eine feste und beständige Verbindung zwischen der Vergussmasse mit dem Substrat gegeben, so dass laterale Bewegungen zwischen dem Substrat und der Vergussmasse verhindert werden.

Die Erfindung gibt daher eine Vorrichtung an, die eine Leiterplatte zum Tragen einer elektrischen Schaltung, ein Gehäuse zum Einhausen der elektrischen Leiterplatte und eine im Gehäuse aufgenommene Vergussmasse umfasst, die die elektrische Leiterplatte wenigstens teilweise umgibt. Dabei kann die Vergussmasse am Gehäuse haften. Das Gehäuse weist ferner eine Wandung auf, von der sich die Vergussmasse lösen kann.

Durch das Einführen einer Wandung im Gehäuse, die sich von der restlichen Gehäuse unterscheidet und ein Ablösen der Vergussmasse vom Gehäuse zulässt, kann sich ein Entspannungsspalt zwischen dem Gehäuse und dem Substrat ausbilden, so dass von der Vergussmasse auf das Substrat übertragene mechanische Belastungen reduziert werden. Darüber hinaus birgt der gehäuseseitige Entspannungsspalt den weiteren Vorteil, dass die sich im Entspannungsspalt sammelnden, eindiffundierten Verschmutzungen, wie beispielsweise Feuchtigkeit, keine Beschädigung der Schaltung durch Migrations- und Korrosionseffekte bewirken können. Dies wäre bei substratseitig ausgebildeten Entspannungsspalten eine wahrscheinliche Ausfallursache.

In einer Weiterbildung der Erfindung unterscheidet sich eine Oberfläche der Wandung von einer restlichen Oberfläche des Gehäuses. Dieser Unterschied kann auf jede beliebige Weise bereitgestellt werden. So können das Gehäuse und die Wandung jeweils unterschiedlichen Oberflächenbehandlungen unterworfen werden, die zu den unterschiedlichen angegebenen Eigenschaften für das Gehäuse und die Wandung führt. Alternativ oder zusätzlich können das Gehäuse und die Wandung bei der Verarbeitung mit unterschiedlichen Temperaturen aufgewärmt sein, so dass die Vergussmasse am Gehäuse haften bleibt, während sie sich von der Wandung löst.

Es ist bevorzugt, dass die Oberfläche der Wandung und die restlichen Oberflächen des Gehäuses und/oder die Oberfläche des Substrats so ausgebildet sind, dass die Adhäsionskraft zwischen der Vergussmasse und der Oberfläche der Wandung geringer ist als die Adhäsionskraft zwischen der Vergussmasse und der restlichen Oberfläche des Gehäuses und/oder der Oberfläche des Substrats, insbesondere wobei die Adhäsionskraft jeweils auf einen definierten Referenzflächeninhalt oder eine infinitesimale Teilkraft bezogen ist.

In einer besonderen Weiterbildung der Erfindung ist die Wandung ein in das Gehäuse eingelegtes Material. Das Material kann beliebig sein. So kann als Material ein den Reibbeiwert des Gehäuses im Bereich der Wandung reduzierender Flüssigkeitsfilm, wie ein Ölfilm verwendet werden. Alternativ kann eine eingebrachte Verschmutzung, die ebenfalls zum Ablösen der Vergussmasse von der Gehäuseoberfläche führt, verwendet werden. Der Vorteil, als Wandung ein Material in das Gehäuse einzulegen ist, dass zunächst ein an sich bekanntes Gehäuse in der bekannten Weise hergestellt werden kann. Dieses bekannte Gehäuse lässt sich dann in der angegebenen Weise modifizieren, so dass an einem herkömmlichen Herstellungsprozess für die angegebene Vorrichtung kaum Änderungen notwendig sind.

In einer bevorzugten Weiterbildung der Erfindung ist das Material im Gehäuse befestigt, so dass das Material beim Einfüllen der Vergussmasse in das Gehäuse nicht auf- oder anderweitig wegschwimmen kann.

In einer alternativen oder zusätzlichen Weiterbildung ist das Material als Lack oder Folie ausgebildet, die sich beide auf technisch einfache Weise an fest definierten Stellen im Gehäuse einbringen lassen.

In einer anderen Weiterbildung der Erfindung weist das Gehäuse eine Gehäuseunterseite, eine der Gehäuseunterseite gegenüberliegende Gehäuseoberseite mit einer Gehäuseöffnung und eine die Gehäuseunterseite und die Gehäuseoberseite verbindende Mantelseite auf, wobei die Wandung an der Gehäuseunterseite ausgebildet ist. Mit anderen Worten bildet sich der Entspannungsspalt an einer der Gehäuseöffnung gegenüberliegenden Stelle aus, so dass ein Eindringen von Verunreinigungen in den Entspannungsspalt minimiert wird.

In einer besonderen Weiterbildung der Erfindung weist das Substrat eine Substratoberseite und eine der Substratoberseite gegenüberliegende Substratunterseite mit der elektrischen Schaltung auf, die im Gehäuse zur Gehäuseunterseite gerichtet ist. Mit anderen Worten ist der Entspannungsspalt zwischen der Substratoberseite und der Gehäuseunterseite angeordnet. Die Vergussmasse haftet damit am Gehäusemantel, der seitlich zur Substratoberseite ausgebildet ist. Die feste Verbindung zwischen Vergussmasse und Gehäusemantel minimiert auf diese Weise laterale Bewegungen zwischen der Substratoberseite und der Vergussmasse weiter, wodurch elektronischen Bauelemente auf dem Substrat und ihre elektrischen Kontaktierungsstellen noch besser vor mechanischer Beanspruchung geschützt sind.

In einer anderen Ausführung der Erfindung weist das Substrat eine Substratoberseite und eine der Substratoberseite gegenüberliegende Substratunterseite auf. Dabei sind die Substratoberseite und/oder die Substratunterseite plasmabehandelt. Das heißt, dass entweder eine zur Gehäuseunterseite gerichtete Seite des Substrats oder eine zur Gehäuseoberseite gerichtete Seite des Substrats plasmabehandelt sein kann. Unter einem Plasma versteht man, aufgeheizte Materie, der im gasförmigen Zustand soviel elektrische Energie zugeführt ist, dass sie elektrisch leitend ist, obwohl sie nach außen hin neutral bleibt. Mit den im Plasma enthaltenen aktiven Teilchen kann die Oberfläche des Substrats so modifiziert werden, dass eine optimale Haftung zu der Vergussmasse gegeben ist.

In einer noch anderen Ausführung der Erfindung ist eine Innenseite des Gehäuses plasmabehandelt. Mit den im Plasma enthaltenen aktiven Teilchen kann die Oberfläche an der Innenseite des Gehäuses so modifiziert werden, dass eine optimale Haftung zu der Vergussmasse gegeben ist

In einer besonderen Weiterbildung ist die Oberfläche im Inneren des Gehäuses und/oder des Substrats dabei plasmagereinigt. Mit Hilfe der Plasmen ist es dabei möglich, die Oberfläche im Inneren des Gehäuses und/oder des Substrats noch besser von verschiedensten Materialien wie zum Beispiel Kohlenstoffverbindungen zu befreien. Dies verbessert die Haftung der Vergussmasse im Gehäuse und/oder am Substrat und verbessert den Schutz des Substrats vor mechanischen Spannungen, die aus Bewegungen der Vergussmasse her rühren.

In einer weiteren besonderen Weiterbildung ist die Oberfläche im Inneren des Gehäuses und/oder des Substrats plasmaaktiviert. Unter einer Aktivierung wird dabei eine Erhöhung der Oberflächenenergie und/oder -spannung verstanden. Diese erhöhte Oberflächenenergie erhöht die Haftung der Vergussmasse an der Oberfläche im Inneren des Gehäuses und/oder des Substrats weiter.

Die Erfindung gibt auch ein Verfahren zum Herstellen einer Vorrichtung mit einem Substrat zum Tragen einer elektrischen Schaltung und einem eine Gehäuseunterseite und eine der Gehäuseunterseite gegenüberliegende Gehäuseoberseite mit einer Gehäuseöffnung aufweisendes Gehäuse zum Einhausen des Substrats an, dass die Schritte Aufbringen eines Materials auf die Gehäuseunterseite und Vergießen des Gehäuses mit einer Vergussmasse umfasst. Dabei kann die Vergussmasse am Gehäuse haften und sich vom Material lösen.

Weiterbildungen des Verfahrens können Verfahrensschritte sein, die die Merkmale der angegebenen Vorrichtung gemäß den Unteransprüchen sinngemäß realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

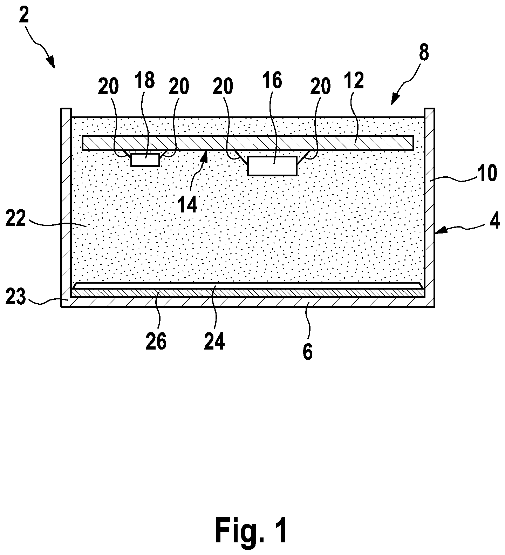

Fig. 1 eine schematische Darstellung einer beispielhaften Vorrichtung gemäß der Erfindung zeigt.

Es wird auf Fig. 1 Bezug genommen, die eine schematische Darstellung einer beispielhaften Vorrichtung 2 gemäß der Erfindung zeigt.

Die Vorrichtung 2 weist ein Gehäuse 4 auf, das einen Gehäuseboden 6, eine dem Gehäuseboden 6 gegenüberliegende Gehäuseöffnung 8 und eine den Gehäuseboden 6 und die Gehäuseöffnung 8 verbindenden Gehäusemantel 10.

In dem Gehäuse 4 ist ein Substrat 12 eingehaust, das eine elektrische Schaltung 14 auf seiner zum Gehäuseboden 6 gerichteten Seite trägt. In Fig. 1 sind von der Schaltung 14 ein erstes elektronisches Bauelement 16 und ein zweites elektronisches Bauelement 18 angedeutet, die jeweils zwei elektrische Kontakte 20 zu nicht gezeigten Leiterbahnen der elektronischen Schaltung 14 umfassen. Das Substrat 12 kann dabei eine Leiterplatte aus Thermoplast, aus Duroplast oder aus Polyimid, oder ein Keramikträger sein.

Die elektrische Schaltung 14 ist in dem Gehäuse 4 von einer Vergussmasse 22 umgeben. Die Vergussmasse haftet an der Wand 23 des Gehäuses, die vom Gehäuseboden 6 und dem Gehäusemantel 10 gebildet ist. Am Gehäuseboden 6 ist zwischen der Vergussmasse 22 und dem Gehäuseboden 6 ein Entspannungsspalt 24 vorhanden, der bei der Herstellung der dargestellten Vorrichtung 2 durch ein auf die Wand 23 am Gehäuseboden 6 aufgebrachtes Material 26 ausgebildet wird, an dem die Vergussmasse 22 nicht haften kann. Das Material 26 kann als Antihaftschicht, beispielsweise in Form von Teflon oder als nichtklebende Schicht beispielsweise in Form von Silikon auf dem Gehäuseboden 6 befestigt sein.

Zur Herstellung der Vorrichtung 2 wird zunächst das Material 26 auf dem Gehäuseboden 6 aufgebracht und danach das Substrat 12 im Gehäuse 4 in der gezeigten Weise angeordnet. Abschließend wird das Gehäuse 4 mit der Vergussmasse 22 ausgegossen. Die Vergussmasse 22 kann beispielsweise ein Kunststoff wie Polyurethan sein, die in das Gehäuse 4 eingefüllt wird und im Gehäuse 4 auspolymerisiert.

## Patentansprüche

1. Vorrichtung (2) umfassend ein Substrat (12) zum Tragen einer elektrischen Schaltung (14), ein Gehäuse (4) mit einer Gehäuseunterseite (6) und einer der Gehäuseunterseite gegenüberliegenden Gehäuseoberseite (8) zum Einhausen des Substrats (12), wobei in dem Gehäuse ein Substrat mit einer elektrischen Schaltung eingehaust ist, wobei das Gehäuse mit einer Vergussmasse derart ausgegossen ist, dass die Schaltung und das Substrat in dem Gehäuse von der Vergussmasse umgeben sind, wobei die Vergussmasse (22) am Gehäuse (4) haften kann **dadurch gekennzeichnet, dass** auf die Gehäuseunterseite (6) ein Material (26) aufgebracht ist, an dem die Vergussmasse nicht haften kann, und die restlichen Oberflächen des Gehäuses (4) und/oder die Oberfläche des Substrats so ausgebildet sind, dass die Adhäsionskraft zwischen der Vergussmasse (22) und der Oberfläche des auf die Gehäuseunterseite aufgebrachten Materials (26) geringer ist als die Adhäsionskraft zwischen der Vergussmasse (22) und der restlichen Oberfläche des Gehäuses und/oder der Oberfläche des Substrats, insbesondere wobei die Adhäsionskraft jeweils auf einen definierten Referenzflächeninhalt oder eine infinitesimale Teilkraft bezogen ist, und wobei an der Gehäuseunterseite (6) zwischen der Vergussmasse (22) und der Gehäuseunterseite ein Entspannungsspalt vorhanden ist, der bei der Herstellung der Vorrichtung durch das auf die Gehäuseunterseite (6) aufgebrachte Material (26) ausgebildet wird, an dem die Vergussmasse nicht haften kann.

2. Vorrichtung (2) nach Anspruch 1, wobei das Material (26) in das Gehäuse eingelegt ist.

3. Vorrichtung (2) nach Anspruch 2, wobei das Material im Gehäuse (4) befestigt ist.

4. Vorrichtung (2) nach Anspruch 3, wobei das Material als Lack oder Folie ausgebildet ist.

5. Vorrichtung (2) nach einem der vorstehenden Ansprüche, wobei die Gehäuseoberseite (8) eine Gehäuseöffnung aufweist und das Gehäuse eine die Gehäuseunterseite (6) und die Gehäuseoberseite (8) verbindende Mantelseite (10) aufweist.

6. Vorrichtung (2) nach Anspruch 5, wobei das Substrat (12) eine Substratoberseite und eine der Substratoberseite gegenüberliegende Substratunterseite mit der elektrischen Schaltung (14) aufweist, die im Gehäuse (4) zur Gehäuseunterseite (6) gerichtet ist.

7. Vorrichtung (2) nach einem der vorstehenden Ansprüche, wobei das Substrat (12) eine Substratoberseite und eine der Substratoberseite gegenüberliegende Substratunterseite aufweist und wobei die Substratoberseite und/oder die Substratunterseite plasmabehandelt ist, insbesondere mit einer Plasmaaktivierung behandelt.

8. Vorrichtung (2) nach einem der vorstehenden Ansprüche, wobei eine Innenseite des Gehäuses (4) plasmabehandelt ist, insbesondere mit einer Plasmaaktivierung behandelt und die Oberfläche des auf die Gehäuseunterseite aufgebrachten Materials (26) insbesondere nicht plasmabehandelt ist.

9. Verfahren zum Herstellen einer Vorrichtung (2) mit einem Substrat (12) zum Tragen einer elektrischen Schaltung (14) und einem eine Gehäuseunterseite (6) und eine der Gehäuseunterseite (6) gegenüberliegende Gehäuseoberseite (8) mit einer Gehäuseöffnung aufweisenden Gehäuse (4) zum Einhausen des Substrats (12) umfassend zunächst Aufbringen eines Materials (26) auf die Gehäuseunterseite (6), dann Einhausen eines Substrats mit einer elektrischen Schaltung in dem Gehäuse und abschließend Ausgießen des Gehäuses (4) mit einer Vergussmasse (22), wobei die Vergussmasse (22) am Gehäuse (22) haften und sich vom Material (26) lösen kann und wobei das Gehäuse mit der Vergussmasse derart ausgegossen wird, dass die Schaltung und das Substrat in dem Gehäuse von der Vergussmasse umgeben sind, wobei die Vergussmasse (22) an dem Material (26) nicht haften kann und die Oberfläche des Materials (26) und die restlichen Oberflächen des Gehäuses (4) und/oder die Oberfläche des Substrats so ausgebildet werden, eine Adhäsionskraft zwischen der Vergussmasse (22) und der Oberfläche des Materials (26) geringer ist als die Adhäsionskraft zwischen der Vergussmasse und der restlichen Oberfläche des Gehäuses und/oder der Oberfläche des Substrats, insbesondere wobei die Adhäsionskraft jeweils auf einen definierten Referenzflächeninhalt oder eine infinitesimale Teilkraft bezogen ist, und wobei bei der Herstellung der Vorrichtung durch das auf die Gehäuseunterseite (6) aufgebrachte Material (26) an der Gehäuseunterseite (6) zwischen der Vergussmasse (22) und der Gehäuseunterseite (6) ein Entspannungsspalt ausgebildet wird.

## Claims

1. Apparatus (2) comprising a substrate (12) for supporting an electrical circuit (14), a housing (4) with a housing bottom side (6) and a housing top side (8), which is situated opposite the housing bottom side, for enclosing the substrate (12), wherein a substrate with an electrical circuit is enclosed in the housing, wherein a potting compound is poured into the housing in such a way that the circuit and the substrate in the housing are surrounded by the potting compound, wherein the potting compound (22) can adhere to the housing (4), **characterized in that** a material (26) to which the potting compound cannot adhere is applied to the housing bottom side (6), and the remaining surfaces of the housing (4) and/or the surface of the substrate are formed such that the adhesion force between the potting compound (22) and the surface of the material (26) which is applied to the housing bottom side is lower than the adhesion force between the potting compound (22) and the remaining surface of the housing and/or of the surface of the substrate, in particular wherein the adhesion force is in each case based on a defined reference area or an infinitesimal partial force, and wherein there is a strain-relief gap on the housing bottom side (6) between the potting compound (22) and the housing bottom side, the said strain-relief gap being formed, during production of the apparatus, by the material (26) which is applied to the housing bottom side (6) and to which the potting compound cannot adhere.

2. Apparatus (2) according to Claim 1, wherein the material (26) is inserted into the housing.

3. Apparatus (2) according to Claim 2, wherein the material is fixed in the housing (4).

4. Apparatus (2) according to Claim 3, wherein the material is in the form of a coating or film/foil.

5. Apparatus (2) according to one of the preceding claims, wherein the housing top side (8) has a housing opening, and the housing has a casing side (10) which connects the housing bottom side (6) and the housing top side (8).

6. Apparatus (2) according to Claim 5, wherein the substrate (12) has a substrate top side and a substrate bottom side which is situated opposite the substrate top side and comprises the electrical circuit (14) which is directed towards the housing bottom side (6) in the housing (4).

7. Apparatus (2) according to one of the preceding claims, wherein the substrate (12) has a substrate top side and a substrate bottom side which is situated opposite the substrate top side, and wherein the substrate top side and/or the substrate bottom side are/is plasma-treated, in particular treated with a plasma activation.

8. Apparatus (2) according to one of the preceding claims, wherein an inner side of the housing (4) is plasma-treated, in particular treated with a plasma activation, and the surface of the material (26) which is applied to the housing bottom side is, in particular, not plasma-treated.

9. Method for producing an apparatus (2) having a substrate (12) for supporting an electrical circuit (14) and having a housing (4), which has a housing bottom side (6) and a housing top side (8), which is situated opposite the housing bottom side (6) and comprises a housing opening, for enclosing the substrate (12), comprising first applying a material (26) to the housing bottom side (6), then enclosing a substrate comprising an electrical circuit in the housing and finally pouring a potting compound (22) into the housing (4), wherein the potting compound (22) can adhere to the housing (22) and detach itself from the material (26), and wherein the potting compound is poured into the housing in such a way that the circuit and the substrate in the housing are surrounded by the potting compound, wherein the potting compound (22) cannot adhere to the material (26) and the surface of the material (26) and the remaining surfaces of the housing (4) and/or the surface of the substrate are formed such that an adhesion force between the potting compound (22) and the surface of the material (26) is smaller than the adhesion force between the potting compound and the remaining surface of the housing and/or of the surface of the substrate, in particular wherein the adhesion force is in each case based on a defined reference area or an infinitesimal partial force, and wherein a strain-relief gap is formed on the housing bottom side (6) between the potting compound (22) and the housing bottom side (6), during production of the apparatus, by the material (26) which is applied to the housing bottom side (6).

## Revendications

1. Dispositif (2) comprenant un substrat (12) destiné à supporter un circuit électrique (14), un boîtier (4) pourvu d'un côté inférieur de boîtier (6) et d'un côté supérieur de boîtier (8), à l'opposé du côté inférieur de boîtier, destiné à loger le substrat (12), un substrat comprenant un circuit électrique étant logé dans le boîtier, le boîtier étant garni d'une masse de scellement de telle sorte que le circuit et le substrat dans le boîtier sont entourés de la masse de scellement, la masse de scellement (22) pouvant adhérer au boîtier (4), **caractérisé en ce que** sur le côté inférieur de boîtier (6) est appliqué un matériau (26) auquel la masse de scellement ne peut pas adhérer, et les surfaces restantes du boîtier (4) et/ou la surface du substrat sont configurées de telle sorte que la force d'adhérence entre la masse de scellement (22) et la surface du matériau (26) appliqué sur le côté inférieur de boîtier est inférieure à la force d'adhérence entre la masse de scellement (22) et la surface restante du boîtier et/ou la surface du substrat, la force d'adhérence étant respectivement rapportée à une superficie de référence définie ou à une force partielle infinitésimale, et un interstice de soulagement des contraintes étant présent sur le côté inférieur de boîtier (6) entre la masse de scellement (22) et le côté inférieur de boîtier, lequel est formé lors de la fabrication du dispositif par le matériau (26) appliqué sur le côté inférieur de boîtier (6) auquel la masse de scellement ne peut pas adhérer.

2. Dispositif (2) selon la revendication 1, le matériau (26) étant déposé dans le boîtier.

3. Dispositif (2) selon la revendication 2, le matériau étant fixé dans le boîtier (4).

4. Dispositif (2) selon la revendication 3, le matériau étant réalisé sous la forme de vernis ou d'un film.

5. Dispositif (2) selon l'une des revendications précédentes, le côté supérieur de boîtier (8) possédant une ouverture de boîtier et le boîtier possédant un côté d'enveloppe (10) qui relie le côté inférieur de boîtier (6) et le côté supérieur de boîtier (8).

6. Dispositif (2) selon la revendication 5, le substrat (12) possédant un côté supérieur de substrat et un côté inférieur de substrat, à l'opposé du côté supérieur de substrat, comprenant un circuit électrique (14) qui est dirigé vers le côté inférieur de boîtier (6) dans le boîtier (4).

7. Dispositif (2) selon l'une des revendications précédentes, le substrat (12) possédant un côté supérieur de substrat et un côté inférieur de substrat, à l'opposé du côté supérieur de substrat, et le côté supérieur de substrat et/ou le côté inférieur de substrat étant traités au plasma, notamment traités avec une activation au plasma.

8. Dispositif (2) selon l'une des revendications précédentes, un côté intérieur du boîtier (4) étant traité au plasma, notamment traité avec une activation au plasma, et la surface du matériau (26) appliqué sur le côté inférieur de boîtier n'étant notamment pas traitée au plasma.

9. Procédé pour fabriquer un dispositif (2) comprenant un substrat (12) destiné à supporter un circuit électrique (14) et un boîtier (4) possédant un côté inférieur de boîtier (6) et un côté supérieur de boîtier (8) muni d'une ouverture de boîtier, à l'opposé du côté inférieur de boîtier (6), destiné à loger le substrat (12), comprenant tout d'abord l'application d'un matériau (26) sur le côté inférieur de boîtier (6), puis le logement d'un substrat comprenant un circuit électrique dans le boîtier et ensuite la garniture du boîtier (4) avec une masse de scellement (22), la masse de scellement (22) pouvant adhérer au boîtier (22) et pouvant se détacher du matériau (26) et le boîtier étant garni de la masse de scellement de telle sorte que le circuit et le substrat sont entourés par la masse de scellement dans le boîtier, la masse de scellement (22) ne pouvant pas adhérer au matériau (26) et la surface du matériau (26) ainsi que les surfaces restantes du boîtier (4) et/ou la surface du substrat étant configurées de telle sorte qu'une force d'adhérence entre la masse de scellement (22) et la surface du matériau (26) est inférieure à la force d'adhérence entre la masse de scellement et la surface restante du boîtier et/ou la surface du substrat, la force d'adhérence étant notamment respectivement rapportée à une superficie de référence définie ou à une force partielle infinitésimale, et un interstice de soulagement des contraintes étant formé sur le côté inférieur de boîtier (6), entre la masse de scellement (22) et le côté inférieur de boîtier (6), lors de la fabrication du dispositif par le matériau (26) appliqué sur le côté inférieur de boîtier (6).
